# EUROPÄISCHE PATENTSCHRIFT

(11) **EP 2 089 491 B1**
(45) Veröffentlichungstag und Bekanntmachung des Hinweises auf die Patenterteilung: **10.04.2013**
(21) Anmeldenummer: 07818739.0
(22) Anmeldetag: 05.10.2007
(51) Int. Cl.: C09K 13/06, H01L 21/306

(54) **DRUCKFÄHIGES MEDIUM ZUM ÄTZEN VON OXIDISCHEN, TRANSPARENTEN UND LEITFÄHIGEN SCHICHTEN**
PRINTABLE MEDIUM FOR ETCHING OF OXIDIC, TRANSPARENT AND CONDUCTING LAYERS
AGENT ADAPTÉ À L'IMPRESSION POUR LA GRAVURE DE COUCHES CONDUCTRICES, OXYDIQUES ET TRANSPARENTES

(30) Priorität: 30.10.2006 DE 102006051735
(43) Veröffentlichungstag der Anmeldung: 19.08.2009
(73) Patentinhaber: Merck Patent GmbH, 64293 Darmstadt (DE)
(72) Erfinder: STOCKUM, Werner, 64354 Reinheim (DE); KUEBELBECK, Armin, 64625 Bensheim (DE)
(86) Internationale Anmeldenummer: PCT/EP2007/008663
(87) Internationale Veröffentlichungsnummer: WO 2008/052637

(56) Entgegenhaltungen:
- WO-A-2006/074791
- WO-A-2007/009546
- US-A- 3 904 443

## Beschreibung

Die vorliegende Erfindung betrifft neue druckfähige Ätzmedien mit verbesserten Eigenschaften zur Verwendung im Herstellungsprozess von Solarzellen. Es handelt sich dabei um entsprechende partikelhaltige Zusammensetzungen, durch die sehr selektiv feinste Linien und Strukturen geätzt werden können, ohne angrenzende Flächen zu beschädigen oder anzugreifen.

### Stand der Technik und Aufgabe der Erfindung

Während des Herstellungsprozesses von Solarzellen müssen u. a. Oxidschichten auf einem Trägermaterial strukturiert werden. Üblicherweise besteht eine kristalline Silizium-Solarzelle aus einem p-leitenden Substrat, in das auf der Vorderseite eine homogen dicke Schicht einer n-leitenden Substanz, beispielsweise Phosphor, eindiffundiert wird. Auf der Vorder- und Rückseite des Wafers wird zur Ableitung des unter Lichteinfall erzeugten Stroms eine metallisch leitende Kontaktierung aufgebracht. Im Hinblick auf eine kostengünstige und massenfertigungstaugliche Herstellungsweise wird die Kontaktierung üblicherweise mittels Siebdrucktechnik erzeugt.

Neben den Oxidschichten, die im Rahmen der Solarzellenherstellung strukturiert werden müssen, sind auch Siliziumnitridschichten zu ätzen. Zur Ätzung von entsprechenden Nitridschichten müssen die angewandten Methoden abgewandelt und die Ätzpasten in geeigneter Weise angepasst werden.

Die Oberflächen kristalliner Silizium Solarzellen sind während des Herstellungsprozesses, und gegebenenfalls auch nach dessen Ende, mit dünnen anorganischen Schichten belegt. Diese Schichten haben Stärken im Bereich von 20 bis 200 nm, in den meisten Fällen im Bereich von 50 bis 150 nm.

Im Verlauf des Produktionsprozesses der kristallinen Silizium-Solarzellen ist es daher in mehreren Prozessschritten vorteilhaft, in diese anorganischen Schichten der Solarzelle feine Linien einzuätzen.

Diese Öffnungen in der Oberfläche der Solarzelle können beispielsweise zur Erzeugung eines sogenannten selektiven Emitters, auch 2-Stufen-Emitter genannt, verwendet werden. Dazu wird in die partiellen Öffnungen einer auf dem Silizium befindlichen Diffusionsbarriere in einem nachfolgenden Diffusionsschritt, eine hohe n-Dotierung, bevorzugt durch eindiffundierenden Phosphor, erzeugt.

Unter anorganischen Oberflächen werden in der vorliegenden Beschreibung oxidische und nitridhaltige Verbindungen des Siliziums verstanden, insbesondere Siliziumoxid- und Siliziumnitrid-Oberflächen. Die Wirkungsweise solcher Diffusionsbarrieren sind dem Fachmann bekannt und in der Literatur beschrieben [A. Goetzberger; B. Voß; J. Knobloch, Sonnenenergie: Photovoltaik, Teubner Studienbücher Stuttgart 1997, pp 40; 107]. Diese Diffusionsbarrieren können dabei auf vielfältige Weise erzeugt werden:

Sehr dichte Siliziumdioxid-Schichten werden beispielsweise durch Temperaturbehandlung von Silizium in sauerstoffhaltiger Atmosphäre bei Temperaturen im Bereich von 900°C erhalten (thermisches Oxid).

Dem Fachmann ebenfalls bekannt ist die Abscheidung von Siliziumdioxid per CVD-Verfahren. Je nach Reaktionsführung unterscheidet man dabei u.a. in folgende Verfahren
- APCVD (athmospheric pressure CVD)
- PE-CVD (plasma enhanced CVD)
- LP-CVD (low pressure CVD)

Diesen Verfahren ist gemeinsam, dass aus der Gasphase eines flüchtigen Precursors, im Beispiel von Siliziumdioxid sind dies beispielsweise Silan (SiH₄) oder TEOS (Tetraethylorthosilikat), durch zersetzende Abscheidung des Precursors auf dem Zielsubstrat, die gewünschte anorganische Verbindung erhalten wird.

Auch mittels nasschemischer Beschichtung mit einem flüssigen oder gelösten festen Precursor in einem Lösungsmittel oder Lösungsmittelgemisch, können Siliziumdioxid-Schichten erhalten werden, die eine Diffusionssperre darstellen. Diese flüssigen Systeme werden meist per Spin-Coating auf das zu beschichtende Substrat aufgetragen. Dem Fachmann sind diese Systeme als Spin-on-Glass (SOG) bekannt.

In vielen Fällen verbleibt die aufgebrachte SiO₂ Schicht auch als reflexmindernde Passivierungsschicht. Dies ist insbesondere bei thermisch gewachsenem SiO₂ häufig der Fall.

Außer Siliziumoxidschichten transparente leitfähige Schichten (TCO) eine wichtige Rolle (z.B. LC-Displays, Touchpanel etc). Neben binär oder ternär gedopten ZnO-Verbindungen (wie z.B. Indium-Zinkoxid, Al-ZnO, Antimon-ZnO) sind besonders die Indiumzinnoxidschichten weit verbreitet. Indiumzinnoxide sind Mischoxide, bestehend aus Indiumoxid (In₂O₃) und Zinn(IV)oxid (SnO₂) (aber auch mit andern Dotanden wir z.B. Fluor als FI:SnO₂ verwendbar). Im folgenden werden diese TCO-Schichten exemplarisch als ITO bezeichnet. Diese transparenten Halbleiter besitzen die Eigenschaft elektrisch leitend und transparent zu sein. In der Elektronikindustrie werden sie für die Herstellung von Dünnschicht-Solarzellen, transparenten Elektroden in Flüssigkristallbildschirmen, organischen Leuchtdioden und Touchscreens eingesetzt. Als stark die Infrarotstrahlung reflektierender Halbleiter, wird ITO vereinzelt auch großflächig als Wärmeschutz auf Fensterglasscheiben aufgebracht. Ebenso können verschiedenste Oberflächen, beispielsweise Kunststofffolien, mit ITO beschichtet werden, damit sich diese nicht elektrostatisch aufladen.

Üblicherweise besteht ITO aus 90% Indiumoxid (In₂O₃) und 10% Zinn(IV)oxid (SnO₂). Das Zinn(IV)oxid erzeugt als Dotiermittel die für eine gute elektrische Leitfähigkeit notwendigen Störstellen im Kristallgefüge des Indiumoxids. Dünne Schichten von typischerweise ca. 200 nm weisen eine hohe Transparenz auf und haben einen Flächenwiderstand von ca. 6 Ohm/cm².

ITO wird üblicherweise durch Kathodenzerstäubung auf die entsprechenden Substrate - fast immer Gläser - aufgebracht. ITO kann aber auch im Hochvakuum aufgedampft werden, wobei allerdings die bedampften Bauteile auf bis zu 360°C erwärmt werden müssen, was die Anwendbarkeit einschränkt.

Siliziumnitrid-Schichten werden in der Technik kristalliner Solarzellen weniger als Diffusionsbarrieren verwendet, obwohl sie dazu prinzipiell ebenfalls geeignet sind. Siliziumnitrid-Schichten werden im wesentlichen als Passivierungs- und Antireflex-Schicht verwendet.

Bei der Herstellung von kristallinen Silizium-Solarzellen ist es vorteilhaft, auch in Siliziumnitrid-Schichten gezielt Öffnungen erzeugen zu können. Als Beispiel sei hier die Auftragung elektrisch leitfähiger Pasten genannt. Üblicherweise werden diese Metallpasten bei Temperaturen von etwa 600°C durch die Siliziumnitrid-Schicht "hindurchgefeuert", wodurch ein elektrischer Kontakt zur Emitterschicht ermöglicht wird. Bedingt durch die hohen Temperaturen können daher polymerbasierende (Epoxy- oder Phenolharz) Metallisierungspasten für diesen Zweck nicht verwendet werden. Auch entstehen während der Durchführung des "Fire-Through-Processes" Kristalldefekte und metallische Kontaminationen im darunter liegenden Silizium. Systembedingt wird außerdem die Passivierungsschicht vollständig durch die darüber liegende aufgedruckte Metallpaste zerstört. Vorteilhafter wäre es daher, eine partielle, schmalere Öffnung in der Siliziumnitrid-Schicht zur elektrischen Kontaktierung herzustellen, und die Erhaltung der Passivierungsschicht in den Randbereichen, die durch die darüber liegende Metallisierungsschicht abgedeckt sind.

Neben den reinen Diffusionsbarrieren, bestehend aus Siliziumdioxid- oder Siliziumnitrid, können auch dünne Glasschichten bei der Herstellung von kristallinen Silizium-Solarzellen verwendet werden.

### Definition von Glas:

An sich wird unter Glas eine einheitliche Masse z. B. Quarzglas, Fensterglas, Borosilikatglas, es werden aber auch dünne Schichten dieser Materialien darunter verstanden, die auf anderen Substraten (z.B. Keramiken, Metallblechen, Siliziumwafer) durch verschiedene, dem Fachmann bekannten Verfahren (CVD, PVD, Spin-on, thermische Oxidation u. a.) erzeugt werden.

Im folgenden werden unter Gläsern Siliziumoxid- und Siliziumnitrid - enthaltende Materialien verstanden, die ohne Auskristallisation der Glaskomponenten im festen amorphen Aggregatzustand vorliegen und in der Mikrostruktur aufgrund fehlender Fernordnung einen hohen Fehlordnungsgrad aufweisen.

Es werden neben dem reinen SiO₂-Glas (Quarzglas) alle Gläser erfasst (z. B. dotierte Gläser wie Borosilikat-, Phosphorsilikat-, Borophosphorsilikatgläser, Farb-, Milch-, Kristallgläser, optische Gläser), die SiO₂ und andere Komponenten enthalten, insbesondere Elemente wie z. B. Kalzium, Natrium, Aluminium, Blei, Lithium, Magnesium, Barium, Kalium, Bor, Berylium, Phosphor, Gallium, Arsen, Antimon, Lanthan, Zink, Thorium, Kupfer, Chrom, Mangan, Eisen, Kobalt, Nickel, Molybdän, Vanadium, Titan, Gold, Platin, Palladium, Silber, Cerium, Cäsium, Niob, Tantal, Zirkonium, Neodym, Praseodym, welche in Form von Oxiden, Karbonaten, Nitraten, Phosphaten, Sulfaten und/oder Halogeniden in den Gläsern auftreten oder als Dotierungselemente in den Gläsern fungieren. Dotierte Gläser sind z. B. Borosilikat-, Phosphorsilikat-, Borophosphorsilikatgläser, Farb-, Milch-, Kristallgläser und optische Gläser.
Das Siliziumnitrid kann ebenfalls andere Elemente, wie Bor, Aluminium, Gallium, Indium, Phosphor, Arsen, oder Antimon enthalten.

Definition von Siliziumoxid- und Siliziumnitrid-basierenden Systemen: Als Siliziumoxid-basierende Systeme werden im folgenden alle kristallinen Systeme definiert, die nicht unter die oben gegebene Definition der amorphen SiO₂-Gläser fallen und auf Siliziumdioxid basieren, das können insbesondere die Salze und Ester der Orthokieselsäure und deren Kondensationsprodukte sein - allgemein vom Fachmann als Silikate bezeichnet - sowie Quarz und Glaskeramiken.

Weiterhin werden andere auf Siliziumoxid- und Siliziumnitrid- basierende Systeme, insbesondere die Salze und Ester der Orthokieselsäure und deren Kondensationsprodukte mit erfasst. Es werden neben dem reinen SiO₂ (Quarz, Tridymit, Cristobalit) alle SiO₂-basierende Systeme erfasst, die aus SiO₂ bzw. aus "diskreten" und/oder verknüpften [SiO₄]-Tetraedern aufgebaut sind wie z. B. Insel-, Gruppen-, Ring-, Ketten-, Band-, Schicht-, Gerüstsilikate und andere Komponenten enthalten, insbesondere Elemente/Komponenten wie z.B. Kalzium, Natrium, Aluminium, Lithium, Magnesium, Barium, Kalium, Berylium, Scandium, Mangan, Eisen, Titan, Zirkonium, Zink, Cerium, Yttrium, Sauerstoff, Hydroxylgruppen, Halogenide.

Als Siliziumnitrid-basierende Systeme werden im folgenden alle kristallinen und teilkristallinen (meist als mikrokristallin bezeichneten) Systeme definiert, die nicht unter die oben gegebene Definition der amorphen Siliziumnitrid-Gläser/-Schichten fallen. Dazu zählen das Si₃N₄ in seinen Modifikationen als α-Si₃N₄ und β-Si₃N₄ und alle kristallinen und teilkristallinen SiNₓ-, SiNₓ:H Schichten. Das kristalline Siliziumnitrid kann andere Elemente wie Bor, Aluminium, Gallium, Indium, Phosphor, Arsen, Antimon enthalten.

### Ätzen von Strukturen

Durch Anwendung von Ätzmitteln, d.h. von chemisch aggressiven Verbindungen kommt es zur Auflösung des dem Angriff des Ätzmittels ausgesetzten Materials. In den meisten Fällen ist es das Ziel, die zu ätzende Schicht vollständig zu entfernen. Das Ende der Ätzung wird erreicht durch das Auftreffen auf eine gegenüber dem Ätzmittel weitgehend resistente Schicht. Daneben gibt es die dem Fachmann bekannte, partielle Abätzung einer Schicht auf eine meist definierte Sollstärke.

Ätzen von Strukturen auf Siliziumoxid- und Siliziumnitrid basierenden Gläsern und anderen Siliziumoxid- und Siliziumnitrid-basierenden Systemen:

Nach dem heutigen Stand der Technik können beliebige Strukturen selektiv in Siliziumoxid- und Siliziumnitrid-basierende Gläser und andere Siliziumoxid- und Siliziumnitrid-basierende Systeme bzw. deren Oberflächen und deren Schichten variabler Dicke direkt durch lasergestützte Ätzverfahren oder nach erfolgter Maskierung nasschemisch ([1] D.J. Monk, D.S. Soane, R.T. Howe, Thin Solid Films 232 (1993), 1; [2]J. Bühler, F.-P. Steiner, H. Baltes, J. Micromech. Microeng. 7 (1997), R1) bzw. durch Trockenätzverfahren geätzt werden ([3] M. Köhler "Ätzverfahren für die Mikrotechnik", Wiley VCH 1983).

Bei den lasergestützten Ätzverfahren rastert der Laserstrahl das gesamte Ätzmuster Punkt für Punkt bzw. Linie für Linie bei vektororientierenden Systemen auf dem Glas ab, was neben einem hohen Präzisionsgrad auch einen beträchtlichen Justier- und Zeitaufwand erfordert.

Die nasschemischen und Trockenätzverfahren beinhalten materialintensive, zeit- und kostenaufwendige Prozessschritte:
A. Maskierung der nicht zu ätzenden Bereiche, z. B. durch:
   - Fotolithografie: Herstellung eines Negativs oder Positivs der Ätzstruktur (abhängig vom Lack), Belackung der Substratoberfläche (z. B. durch Schleuderbelackung mit einem flüssigen Fotolack), Trocknen des Fotolacks, Belichtung der belackten Substratoberfläche, Entwicklung, Spülen, ggf. Trocknen
B. Ätzen der Strukturen durch:
   - Tauchverfahren (z.B. Nassätzen in Nasschemiebänken): Eintauchen der Substrate in das Ätzbad, Ätzvorgang, mehrfaches Spülen in H₂O-Kaskadenspülbecken, Trocknen
   - Spin-on oder Sprühverfahren: Die Ätzlösung wird auf ein drehendes Substrat aufgebracht, der Ätzvorgang kann ohne oder mit Energieeintrag (z.B. IR- oder UV-Bestrahlung) erfolgen, danach folgen Spülen und Trocknen
   - Trockenätzverfahren wie z. B. Plasmaätzen in teuren Vakuumanlagen oder Ätzen mit reaktiven Gasen in Durchflussreaktoren
C. Entfernen des Fotolackes:

In einem letzten Prozessschritt muss der die schützenden Bereiche des Substrates abdeckende Fotolack entfernt werden. Dieses kann durch Lösungsmittel, wie beispielsweise Aceton oder verdünnte wässrige alkalische Lösungen geschehen. Abschließend werden die Substrate gespült und getrocknet.

Ganzflächiges Ätzen von Siliziumoxid- und Siliziumnitrid- basierenden Gläsern und anderen Siliziumoxid- und Siliziumnitrid- basierenden Systemen:
Um Siliziumoxid- und Siliziumnitrid- basierende Gläser und andere Siliziumoxid- und Siliziumnitrid- basierende Systeme und deren Schichten variabler Dicke ganzflächig vollständig oder nur bis in eine bestimmte Tiefe zu ätzen, werden vorwiegend Nassätzverfahren genutzt. Die Siliziumoxid- und Siliziumnitrid- basierenden Gläser und andere Siliziumoxid- und Siliziumnitrid- basierende Systeme und deren Schichten variabler Dicke werden in Ätzbäder, die meist die giftige und stark ätzende Flusssäure und gegebenenfalls Zusätze anderer Mineralsäuren enthalten, getaucht.

Die Nachteile der beschriebenen Ätzverfahren liegen in den zeit-, material- und kostenintensiven Prozessschritten begründet, welche teilweise technologisch und sicherheitstechnisch sehr aufwendig sind und häufig außerdem noch diskontinuierlich durchgeführt werden.

In der internationalen Anmeldung WO 01/83391 A werden Ätzmedien in Form von druckfähigen, homogenen, partikelfreien Ätzpasten mit nichtnewtonschem Fließverhalten zum Ätzen von anorganischen, glasartigen amorphen oder kristallinen Oberflächen, insbesondere von Gläsern oder Keramiken, vorzugsweise auf SiO₂- oder Siliziumnitrid-basierenden Systemen, sowie die Verwendung dieser Ätzmedien beschrieben. In der Anwendung dieser partikelfreien Medien ergeben sich insbesondere beim Bedrucken von Oberflächen Probleme durch ungenügendes Stehvermögen der aufgedruckten Linien, Punkte oder Strukturen (ungenügende Strukturtreue), so dass es zu einer deutlichen Verbreiterung der ursprünglich aufgedruckten Linien kommt (Verlaufen der Ätzspezies auf dem Untergrund).

In US 5,688,366 A werden partikelhaltige Ätzpasten zum Ätzen einer transparent leitfähigen Schicht, wie z. B. einer ITO-Schicht, verwendet. Die verwendeten Ätzpasten werden hergestellt aus aufgeschmolzenem, Kristallwasser enthaltendem Eisenchlorid, Glycerin und Polymerpartikeln. Diese Zusammensetzungen sind geeignet, Linien mit einer Breite von etwa 1 mm zu ätzen. Versuche haben gezeigt, dass diese Ätzpasten nicht geeignet sind, sehr dünne Linien mit einer Breite von weniger als 1 mm sauber und ohne Fehlstellen zu ätzen, und zwar unabhängig davon, ob Polymerpartikel mit einem Durchmesser von 0,01 µm oder von 30 µm zur Herstellung der Pasten eingesetzt werden.

In WO 2006/074791 werden Ätzpasten offenbart, die zum ätzen von sehr gleichmässigen dünnen Linien mit einer Breite von weniger als 100 µm und von feinsten Strukturen auf Siliziumdioxid- und Siliziumnitrid-Schichten insbesondere auch auch in leitfähigen Schichten, welche sich auf Silizium-Solarzellen finden, geeignet sind. Die Ätzpaste enthält eine Ätzende Komponente, ein Lösungsmittel, ein Polymer- und/oder anorganische Partikel, gegebenenfalls mindestens ein homogen gelöstes organisches Verdickungsmittel, gegebenenfalls mindestens eine anorganische und/oder organische Säure, sowie gegebenenfalls Additive wie Entschäumer, Thixotropiermittel, Verlaufsmittel, Entlüfter, Haftvermittler.

### Aufgabenstellung

Aufgabe der vorliegenden Erfindung ist es daher, neue, kostengünstige Ätzpasten zum Ätzen von sehr gleichmäßigen dünnen Linien mit einer Breite von weniger als 100 µm, insbesondere von weniger als 80 µm, und von feinsten Strukturen auf Siliziumdioxid- und/oder Siliziumnitrid-Schichten insbesondere auch in leitfähige Schichten, welche sich auf Silizium-Solarzellen befinden, zur Verfügung zu stellen. Aufgabe der vorliegenden Erfindung ist es auch, neue Ätzmedien zur Verfügung zu stellen, die nach dem Ätzen, in einfacher Weise ohne Rückstände zu hinterlassen von den behandelten Oberflächen zu entfernen sind und gegenüber bekannten Pasten umweltfreundlichere Eigenschaften besitzen.

### Kurze Beschreibung der Erfindung

Die Lösung der Aufgabe erfolgt durch ein neues druckbares, dispensierfähiges, Ätzmedium zum Ätzen von oxidischen transparenten und leitfähigen Oberflächen und -schichten in Form einer Ätzpaste, enthaltend
a) Phosphorsäure in einer Konzentration im Bereich von etwa 35 bis 50 Gew.-%,
b) mindestens ein Lösungsmittel
c) Graphit und/oder Ruß mit einem relativen Partikeldurchmesser im Bereich von 80 nm bis 20 nm und einer spezifischen BET Oberfläche im Bereich von 40 bis 100 m²/g, in einer Menge von weniger 8 Gew.-%, jedoch mehr als 0,5 Gew.-%,
d) gegebenenfalls Verdickungsmittel, und
e) gegebenenfalls Additive wie Entschäumer, Thixotropiermittel, Verlaufsmittel, Entlüfter, Haftvermittler.

In einer besonderen Ausführungsform enthalten solche Ätzmedien Graphit- oder Rußpulver mit relativen Partikeldurchmessern von weniger als 50 nm und einer spezifischen BET Oberfläche im Bereich 50 bis 70 m²/g. Als besonders vorteilhaft hat es sich erwiesen, wenn das Graphit- oder Rußpulver mit relativen Partikeldurchmessern im Bereich von 30 nm bis 45 nm darin enthalten ist. Ganz besonders gute Eigenschaften haben Ätzmedien, enthaltend Rußpulver mit einem relativen Partikeldurchmesser von 40 nm und mit einer spezifischen BET Oberfläche von 62 m²/g. Während in früheren Zusammensetzungen höhere Anteile an Feststoffen nötig waren, werden erfindungsgemäß bereits durch den Zusatz von weniger als 8 Gew.-%, jedoch mehr als 0,5 Gew.-%. Graphit- oder Rußpulver mit den genannten Eigenschaften Zusammensetzungen erhalten, die sich in Form feinster Linien aufdrucken lassen. Besonders gute Eigenschaften weisen Zusammensetzungen auf mit einem Graphit- oder Rußpulver-Gehalt im Bereich von 3 bis 7 Gew.-%, und welche eine Viskosität im Bereich von 25 bis 35 Pas besitzen. Entsprechende Zusammensetzungen lassen sich vorteilhaft bei Temperaturen zwischen 120 - 170 °C zum Ätzen von ITO-Schichten verwenden.

### Beschreibung der Erfindung

Die neuen Pastenformulierungen weisen hinsichtlich der Oberflächenreinigung, Druckpräzision und Abwasserbelastung nach dem Ätzvorgang wesentlich verbesserte Gigenschaften auf. Überraschenderweise wurde getunden, dass die Alzpasten, denen extrem feinpartikuläre anorganischen Pulver, insbesondere feinpartikulärer Graphit und-/oder Ruß zugesetzt wurde, verbesserte Reinigungseigenschaften aufweisen, wenn sie zum Ätzen von ITO bei Temperaturen zwischen 120 - 170 °C eingesetzt werden im Gegensatz zu Pasten, denen handelsüblicher Graphit oder Ruß zugesetzt worden ist. Die anschließende Reinigung der behandelten Oberflächen erfolgt mit DI Wasser.

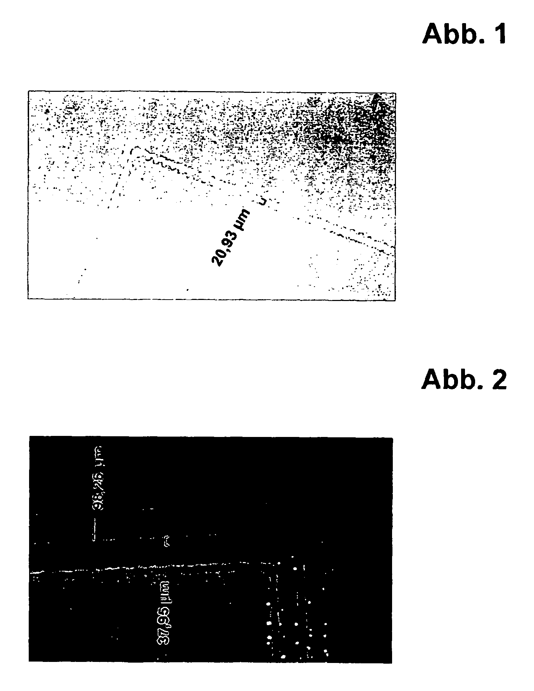

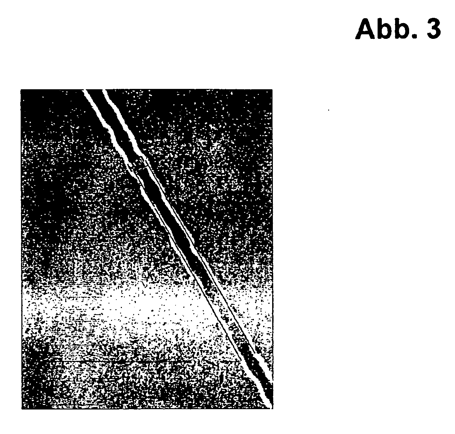

Ein wesentlicher Vorteil der neuen und erfindungsgemäßen Pastenformulierungen besteht weiterhin darin, dass die enthaltenen anorganischen Pulver bei den Ätztemperaturen unverändert bleiben und nicht aufschmelzen, jedoch dazu beitragen, dass die Ätzpaste in dünnsten Linien oder feinsten Strukturen ohne zu verlaufen und auszufransen auf die Oberflächen aufgebracht werden kann und während des Ätzvorgangs an den Wirkort nachdiffundieren kann. Insbesondere durch die Verwendung von anorganischem Graphit- oder Rußpulver mit relativen Partikeldurchmessern von 20 nm bis 80 nm, bevorzugt von 45 nm bis 30 nm, und einer spezifischen BET Oberfläche im Bereich von 40 bis 100 m²/g, bevorzugt von 50 bis 70 m²/g, führen zu verbesserten Ergebnissen. Ganz besonders bevorzugt ist die Verwendung von Rußpulvern mit Partikeldurchmessern von etwa 40 nm und von einer spezifischen BET Oberfläche von etwa 62 m²/g. Die Verwendung dieser Rußpulver führt zu besonders guten Ätzergebnissen. Im Vergleich zur Verwendung von Polymerpulvern, deren kleinste Partikelgrößen bei 3 - 5 µm liegen, können durch den Zusatz von nanopartikulären Rußteilchen wesentlich feinere Linien und kleinere Strukturen gedruckt und geätzt werden, d. h. es wird eine wesentlich verbesserte Druckpräzision erzielt und es können deutlich kleinere Strukturen auf ITO gedruckt und geätzt werden. Folglich ergeben sich neue Anwendungsmöglichkeiten bei einfachen Displays als auch bei hochauflösende TFT Displays, wie die Abbildungen 1 bis 4 zeigen.

Zur Herstellung der erfindungsgemäßen Pasten werden im Handel erhältliche Graphit- bzw. Rußpulver verwendet, welche die oben beschriebenen Eigenschaften aufweisen und die Größen- und Oberflächenanforderungen erfüllen. Beispielhaft sei hier das käufliche Produkt Super P^{™} (conductive Carbon Black, der Firma TIMCAL Graphite & Carbon, Schweiz) genannt. Zur Bestimmung der Partikelgrößen können allgemein übliche Methoden eingesetzt werden. Beispielsweise kann die Partikelgröße mittels Partikelkorrelationsspektroskopie (PCS) ermittelt werden, wobei die Untersuchung mit einem Malvern Zetasizer nach Bedienungsanleitung durchgeführt wird. Dabei wird der Durchmesser der Partikel als d₅₀- oder d₉₀-Wert bestimmt. Die angegebenen Partikeldurchmesser werden bevorzugt als d₅₀-Werte angegeben.

Ermittelt werden können die Partikeldurchmesser generell mittels Laserbeugung, verbunden mit einer online Analyse. Zu diesem Zweck wird ein Laserstrahl in eine Partikelwolke gestrahlt, welche in einem durchsichtigen Gas, z. B. Luft verteilt ist. Die Partikel brechen das Licht, wobei kleine Partikel das Licht in einem größeren Winkel brechen als große Partikel. Der Streuwinkel steht somit in einem direkten Zusammenhang mit der Partikelgröße. Mit abnehmender Partikelgröße nimmt der beobachtete Streuwinkel logarithmisch zu. Das gebrochene Licht wird durch eine Anzahl von Photodetektoren gemessen, die in verschiedenen Winkeln angebracht sind. Die Auswertung der Messungen erfolgen bevorzugt unter Nutzung der Lichtbeugungstheorie von Mie, die auf Maxwells Gleichung des elektromagnetischen Feldes beruht. Basis dieser Theorie sind zwei Annahmen. Einerseits wird angenommen, dass die zu vermessenden Partikel sphärisch sind, was aber nur für wenige Partikel wirklich zutrifft. Aus der gemessenen Laserbeugung wird das Volumen der Partikel berechnet. Andererseits wird von verdünnten Partikelsuspensionen ausgegangen. Genauer beschrieben wird das üblicherweise genutzte Verfahren zur Bestimmung von Partikelgrößen im Nanobereich durch dynamische Licht Streuung in der Broschüre "Dynamic Light Scattering: An Introduction in 30 Minutes", DLS technical note, MRK656-01 von Malvern Instruments Ltd.
Die Bestimmung der Partikelgröße im nanopartikulären Bereich kann auch mit Hilfe von Rasterelektronenmikroskopaufnahmen (REM-Aufnahmen) erfolgen. Zu diesem Zweck können partikelhaltige Emulsionen hergestellt werden, die in einem Spincoating-Verfahren in dünnster Schicht auf eine geeignete Oberfläche aufgebracht werden. Nach dem Verdunsten des Lösungsmittels werden REM-Aufnahmen gemacht und die erfassten Partikeldurchmesser vermessen. Durch statistische Auswertung wird der relative Partikeldurchmesser der vermessenen Probe ermittelt. Standardisierte Methoden zur Ermittlung Partikelgrößen und dafür geeignete Vorrichtungen sind in der ISO 13321, Methods for Determination of Paticle Size Distribution Part 8: Photon correlation Spectroscopy, International Organisation for Standardisation [(ISO) 1996 (First Edition 1996-07-01)] erfasst und beschrieben, einschließlich Methoden zur Ermittlung von Größen im nm-Meßbereich.

Als besonders vorteilhaft hat sich gezeigt, dass durch die erfindungsgemäße Verwendung von nanopartikulärem Ruß sich der Feststoffzusatz in den Ätzpastenzusammensetzungen wesentlich reduzieren lässt. Es wurde überraschend gefunden, dass sich der prozentuale Anteil an Feststoff in der Ätzpaste um mehr als 70 Gew.-% reduzieren lässt, wenn nanopartikuläres Rußpulver eingesetzt wird im Vergleich zur Verwendung von Polymerpartikeln in Pasten mit vergleichbarer Viskosität. Dieses gilt besonders für die Verwendung von Graphit und/oder Ruß mit relativen Partikeldurchmessern im Bereich von 20 nm bis 80 nm und einer spezifischen BET Oberfläche im Bereich von 40 bis 100 m²/g.
Insbesondere wenn Rußpartikel mit relativen Partikeldurchmessern von etwa 40 nm und von einer spezifischen BET Oberfläche von etwa 62 m²/g als Feststoff in einer entsprechenden Zusammensetzung verwendet wird, kann der Feststoffzusatz um etwa 74% reduziert werden im Vergleich zur Zugabe von Polymerpartikeln mit einem relativen Partikeldurchmesser im Bereich von 3 - 5 µm, um eine Paste mit einer Viskosität von weniger als 40 Pas, insbesondere von etwa 30 Pas herzustellen. Auf diese Weise lässt sich eine wesentlich umweltfreundlichere Paste herstellen. Es lässt sich dadurch auch die Verwendungsdauer der zur Entfernung von Schwebstoffteilchen aus dem Abwasser erforderlichen Abwasserfilter, erheblich verlängern, und zwar zur Entfernung der Schwebstoffteilchen aus dem Abwasser, das bei den Spülvorgängen zur Reinigung der geätzten Oberflächen anfällt.

Überraschenderweise wurde durch Messungen gefunden, dass die abgespülten Rußpartikel (aktiver Kohlenstoff) eine adsorptive Wirkung gegenüber den organischen Verdickerzusätzen und organischen Lösemittelanteilen der Paste besitzen. Dieses hat zur Folge, dass sich der BSB5 Wert (mg/l) im Spülwasser durch einfache Partikelfiltration reduzieren lassen kann. Bei dem BSB5-Wert handelt es sich um den Biologischen Sauerstoffbedarf (mg/l) von Abwasser in 5 Tagen, gemessen nach DIN 38409 H51. Während beispielsweise bei Verwendung einer Ätzpaste mit Polymerpartikeln bei sonst gleicher Zusammensetzung ein BSB5-Wert von 14mg/l ermittelt wird, ergibt sich für Pasten mit erfindungsgemäß zugesetzten Rußpartikeln lediglich ein BSB5-Wert von 7-8mg/l bei jeweils gleicher Pastenmenge im Spülwasser (135 mg Paste / 0,5 l Spülwasser).

Als wirksame Ätzkomponente hat sich insbesondere Phosphorsäure als besonders wirksam erwiesen, und zwar in Konzentrationen im Bereich von etwa 35 bis 50 Gew.-%. Als besonders wirksam haben sich Zusammensetzungen mit einer Phosphorsäurekonzentration im Bereich von 40 bis 50 Gew.-% erwiesen. Sie weisen ganz besonders vorteilhafte Eigenschaften auf, da sie sich gut auf die Oberflächen aufdrucken lassen und zu sehr guten Ätzergebnissen führen. Insbesondere bevorzugt sind Ätzpasten mit einem Phosphorsäuregehalt von 45 bis 46 Gew.-%.

Zur Herstellung der Ätzpasten werden die verschiedenen Komponenten nacheinander unter ausreichender Durchmischung miteinander vermischt und zwar derart, dass sich während der Zugabe der Ätzkomponente die Temperatur nur moderat erhöhen kann, sich aber während der Durchmischung eine Paste mit einer geeigneten Viskosität bildet.

Wie oben bereits angedeutet, lassen sich Ätzpasten in besonders feinen Linien und Strukturen verdrucken, wenn darin Graphit und/oder Ruß mit einem relativern Partikeldurchmesser im Bereich von 20 nm bis 80 nm und einer spezifischen BET Oberfläche im Bereich von 40 bis 100 m²/g, enthalten ist. Die Oberflächenbeschaffenheit der Partikeln ist dabei nicht nur für die Eigenschaften als Ätzpaste von Bedeutung, sondern beeinflusst auch wie oben beschrieben erheblich die Umweltverträglichkeit der Pasten.

Zur Herstellung der erfindungsgemäßen Pasten werden daher bevorzugt Graphit und/oder Ruß mit einem relativern Partikeldurchmesser von weniger als 50 nm und einer spezifischen BET Oberfläche im Bereich 50 bis 70 m²/g verwendet. Insbesondere bevorzugt sind solche Pulver mit relativen Partikeldurchmessern im Bereich von 30 nm bis 45 nm, und ganz besonders bevorzugt Rußpulver mit einem relativen Partikeldurchmesser von 40 nm und von einer spezifischen BET Oberfläche von 62 m²/g, da diese Zusammensetzungen zu besonders geringen BSB5-Werte führen.
Um zu den vorteilhaften Pasteneigenschaften zu führen, müssen die Feststoffteilchen in Form von Graphit und/oder Ruß in den Zusammensetzungen in Mengen von weniger als 8 Gew.-% enthalten sein. Bevorzugt werden den Pasten 3 bis 7 Gew.-% des nanopartikulären Graphits oder Rußpulvers zugesetzt. Besonders durch den Zusatz von etwa 5 bis 6 Gew.-% werden Ätzpasten erhalten mit einer Viskosität im Bereich von 25 bis 35 Pas, die sich hervorragend verdrucken lassen, wie die Ätzbilder Abb. 1 bis Abb. 4 sehr deutlich zeigen. Aber auch ein geringerer Zusatz von nanopartikulärem Ruß oder Graphit in einer Menge von 0,5 Gew.-% führt bereits zu einem verbesserten Verhalten während des Verdruckens im Vergleich zur Verwendung von Pasten, worin Polymerpartikel in gleicher Menge vorhanden sind. Bereits diese geringen Partikelmengen ermöglichen ein Verdrucken mit verringerter Linienbreite.

Neben dem nanopartikulären Graphit oder Ruß können in den Pasten Verdickungsmittel enthalten sein, sowie, gegebenenfalls Additive, wie Entschäumungsmittel, Thixotropiermittel, oder Verlaufsmittel, Entlüfter, Haftvermittler. Als Lösungsmittel können Wasser und/oder organische Lösungsmittel eingearbeitet sein. So können die erfindungsgemäßen Pasten neben den Grundbestandteilen Phosphorsäure und Ruß- oder Graphitpulver Wasser, Polyvinylpyrrolidon und 1-Methylpyrrolidon enthalten. Während 1-Methylpyrrolidon in gleichen Teilen wie Phosphorsäure enthalten sein können, ist gewöhnlich Polyvinylpyrrolidon in einer Menge von weniger als 10 Gew.-%, bevorzugt in einer Menge von etwa 5 bis 6 Gew.-% enthalten.

Additive mit für den gewünschten Zweck vorteilhaften Eigenschaften sind Entschäumer, wie z. B. das unter dem Handelsnamen erhältliche TEGO® Foamex N,
Thixotropiermittel, wie BYK® 410, Borchigel® Thixo2,
Verlaufsmittel, wie TEGO® Glide ZG 400,
Entlüfter, wie TEGO® Airex 985 und
Haftvermittler, wie Bayowet® FT 929.
Es versteht sich für den Fachmann von selbst, dass diese Additive auch durch andere im Handel erhältliche, gleichwirkende Produkte ersetzt werden können. Wesentlich ist in diesem Zusammenhang, dass durch die Zugabe solcher Additive die Produkteigenschaften verbessert werden.

Speziell in durchgeführten Versuchen eingesetzte Additive sind auch aus den im folgenden gegebenen Beispielen zu entnehmen.
Diese können die Druckfähigkeit der Ätzpaste positiv beeinflussen. Der Anteil der Additive liegt im Bereich von 0 - 5 Gew % bezogen auf die Gesamtmasse der Ätzpaste.

Die erfindungsgemäßen Ätzpasten lassen sich in bekannter Weise auf die Waferoberflächen aufdrucken. Insbesondere werden sie im Feinliniendruck < 50 µm aufgebracht. Dieses ist beispielsweise möglich bei Verwendung eines Siebes mit folgenden Parametern:

| | |
|---|---|
| Maschenzahl: | Stahlgewebe 350 mesh/inch |
| Fadendurchmesser: | 16 µm |
| Emulsionsdicke: | 10 µm |
| Absprung beim Druckvorgang: | 75 µm |

In den Abbildungen 1 bis 4 werden Ätzergebnisse wiedergegeben, zu deren Erzeugung unterschiedlich dünne Linien gedruckt worden sind.

Darüber hinaus kann man an diesen Abbildungen erkennen, dass mit den erfindungsgemäßen Pasten Linien im Abstand von weniger als 100 µm geätzt werden können, ohne mit Photoresistschichten arbeiten zu müssen. Es ist daher möglich, in einfacher Weise unter Verwendung der erfindungsgemäßen Ätzpasten hochauflösende Ätzstrukturen zu erzeugen.
Abb. 1 zeigt eine Ätzlinie mit einer Breite von 20,93 µm, die in eine ITO-Schicht geätzt worden ist.
Abb. 2 zeigt drei nebeneinander jeweils in einem Abstand von 98,26 µm geätzte Linie mit einer Breite von 37,95 µm
Abb. 3 zeigt die durchgehende Struktur einer 38.4 µm breiten Ätzlinie

Anhand der wiedergegebenen Ätzbilder zeigt sich, dass die erfindungsgemäßen Ätzpasten geeignet sind, auch noch dünnste Linien durchgehend zu ätzen, ohne dass es im Verlauf der Ätzbahnen zu einem Abbruch der Linien kommt.

### Beispiele

Zum besseren Verständnis und zur Verdeutlichung der Erfindung werden im folgenden Beispiele gegeben, die im Rahmen des Schutzbereichs der vorliegenden Erfindung liegen. Diese Beispiele dienen auch zur Veranschaulichung möglicher Varianten. Aufgrund der allgemeinen Gültigkeit des beschriebenen Erfindungsprinzips sind die Beispiele jedoch nicht geeignet, den Schutzbereich der vorliegenden Anmeldung nur auf diese zu reduzieren.

Es versteht sich für den Fachmann von selbst, dass sich sowohl in den gegebenen Beispielen als auch in der übrigen Beschreibung die in den Pastenzusammensetzungen enthaltenen Komponentenmengen in der Summe immer nur zu 100% aufaddieren und nicht darüber hinausgehen können, auch wenn sich aus den angegebenen Prozentbereichen höhere Werte ergeben könnten.

### Beispiel 1

### Ätzpaste mit einem anorganischen nanopartikulären Feststoffzusatz

218 g DI Wasser
223 g 1-Methyl-2-pyrrolidon
1,6g Ethylenglycol
Zu diesem Lösungsmittelgemisch werden unter Rühren nacheinander 465 g Phosphorsäure (85 %)
   und
11 g Polyvinypyrrolidon
zugegeben, wobei Polyvinylpyrrolidon unter starkem Rühren untergemischt werden.
Die klare homogene Mischung wird nun mit
50 g Ruß
versetzt und für 2 Stunden nachgerührt.
Die gebrauchsfertige Paste kann mit einem 280 Mesh Edelstahlgewebe Sieb verdruckt werden. Prinzipiell können auch Polyester oder ähnlich Siebmaterialien verwendet werden. Entscheidend ist, dass das gewählte Siebmaterial inert gegenüber der in der Ätzzusammensetzung enthaltenen Ätzkomponente ist.

Die hergestellte Ätzpaste hat sich über lange Zeit unter Erhalt der vorteilhaften Ätzeigenschaften als lagerstabil erwiesen.
Weitere Beispiele für erfindungsgemäße Zusammensetzungen mit vorteilhaften Eigenschaften werden in den folgenden Tabellen gegeben:

| Ansatz | Triethylen-glycol-mono-methyl-ether [g] | H₂O [g] | Stabiteze QM [g] | Poly-ethylen-glycol [g] | Natrosoi GR250 [g] | Milchsäure (90%ig) [g] | H₃PO₄ (85°ig) [g] | 1-Methyl-2-pyrrolidon [g] | Ruß [g] | Graphit [g] | Ethlen-glycol [g] | PVP [g] |
|---|---|---|---|---|---|---|---|---|---|---|---|---|
| 1 | 0 | 218 | 8 | 4 | 8 | 0 | 465 | 223 | 19 | 0 | 1,6 | 0 |
| 2 | 0 | 219 | 7,7 | 4 | 8.5 | 0 | 463 | 223 | 17 | 0 | 2 | 0 |
| 3 | 0 | 220 | 7,4 | 8 | 9 | 0 | 461 | 223 | 15 | 0 | 2,4 | 0 |
| 4 | 0 | 221 | 7,1 | 8 | 9,5 | 0 | 459 | 223 | 13 | 0 | 2,8 | 0 |
| 5 | 0 | 222 | 6,8 | 0 | 10 | 0 | 457 | 223 | 11 | 0 | 3,2 | 0 |
| 6 | 0 | 223 | 6,5 | 0 | 10,5 | 0 | 455 | 223 | 9 | 0 | 3,6 | 0 |
| 7 | 0 | 224 | 6,2 | 0 | 11 | 0 | 453 | 223 | 7 | 0 | 3 | 0 |
| 8 | 0 | 225 | 5,9 | 0 | 11,5 | 0 | 451 | 223 | 8 | 0 | 2,4 | 0 |
| 9 | 0 | 226 | 5,6 | 0 | 12 | 0 | 449 | 223 | 9 | 0 | 1,8 | 0 |
| 10 | 0 | 227 | 5,3 | 0 | 12,5 | 0 | 447 | 223 | 10 | 0 | 1,2 | 0 |
| 11 | 0 | 228 | 5 | 0 | 13 | 0 | 445 | 223 | 1 | 0 | 0,6 | 0 |
| 12 | 0 | 229 | 4,7 | 0 | 13,5 | 0 | 443 | 223 | 12 | 0 | 0 | 0 |
| 13 | 0 | 0 | 0 | 0 | 0 | 0 | 450 | 466 | 13 | 0 | 0 | 60 |
| 14 | 0 | 0 | 0 | 0 | 0 | 0 | 452 | 464 | 19 | 0 | 0 | 59,5 |
| 15 | 0 | 0 | 0 | 0 | 0 | 0 | 454 | 462 | 25 | 0 | 0 | 59 |
| 16 | 0 | 0 | 0 | 0 | 0 | 0 | 456 | 460 | 31 | 0 | 0 | 58,5 |
| 17 | 0 | 0 | 0 | 0 | 0 | 0 | 458 | 458 | 37 | 0 | 0 | 58 |
| 18 | 0 | 0 | 0 | 0 | 0 | 0 | 460 | 456 | 43 | 0 | 0 | 57,5 |
| 19 | 0 | 0 | 0 | 0 | 0 | 0 | 462 | 454 | 49 | 0 | 0 | 57 |
| 20 | 0 | 0 | 0 | 0 | 0 | 0 | 464 | 452 | 55 | 0 | 0 | 56,5 |
| 21 | 0 | 0 | 0 | 0 | 0 | 0 | 450 | 466 | 61 | 0 | 0 | 60 |
| 22 | 0 | 0 | 0 | 0 | 0 | 0 | 452 | 464 | 67 | 0 | 0 | 59,5 |
| 23 | 0 | 0 | 0 | 0 | 0 | 0 | 454 | 462 | 73 | 0 | 0 | 59 |
| 24 | 0 | 0 | 0 | 0 | 0 | 0 | 456 | 460 | 79 | 0 | 0 | 58,5 |
| 25 | 0 | 0 | 0 | 0 | 0 | 0 | 458 | 458 | 85 | 0 | 0 | 25 |
| 26 | 0 | 0 | 0 | 0 | 0 | 0 | 460 | 456 | 68 | 0 | 0 | 30 |
| 27 | 0 | 0 | 0 | 0 | 0 | 0 | 462 | 454 | 51 | 0 | 0 | 35 |
| 28 | 0 | 0 | 0 | 0 | 0 | 5 | 464 | 452 | 50 | 0 | 0 | 56,5 |
| 29 | 1 | 0 | 0 | 0 | 0 | 5 | 466 | 450 | 49 | 0 | 0 | 56 |
| 30 | 2 | 0 | 0 | 0 | 0 | 5 | 468 | 448 | 48 | 0 | 0 | 55,5 |
| 31 | 2 | 0 | 0 | 0 | 0 | 0 | 470 | 446 | 47 | 0 | 0 | 55 |
| 32 | 0 | 218 | 8 | 4 | 8 | 0 | 465 | 223 | 0 | 19 | 1,6 | 0 |
| 33 | 0 | 219 | 7,7 | 4 | 8,5 | 0 | 463 | 223 | 0 | 17 | 2 | 0 |
| 34 | 0 | 220 | 7,4 | 8 | 9 | 0 | 461 | 223 | 0 | 15 | 2,4 | 0 |
| 35 | 0 | 221 | 7,1 | 8 | 9,5 | 0 | 459 | 223 | 0 | 13 | 2,8 | 0 |
| 36 | 0 | 222 | 6,8 | 0 | 10 | 0 | 457 | 223 | 0 | 11 | 3,2 | 0 |
| 37 | 0 | 223 | 6,5 | 0 | 10,5 | 0 | 455 | 223 | 0 | 9 | 3,6 | 0 |
| 38 | 0 | 224 | 6,2 | 0 | 11 | 0 | 453 | 223 | 0 | 7 | 3 | 0 |
| 39 | 0 | 225 | 5,9 | 0 | 11,5 | 0 | 451 | 223 | 0 | 8 | 2,4 | 0 |
| 40 | 0 | 226 | 5,6 | 0 | 12 | 0 | 449 | 223 | 0 | 9 | 1,8 | 0 |
| 41 | 0 | 227 | 5,3 | 0 | 12,5 | 0 | 447 | 223 | 0 | 10 | 1,2 | 0 |
| 42 | 0 | 228 | 5 | 0 | 13 | 0 | 445 | 223 | 0 | 11 | 0,6 | 0 |
| 43 | 0 | 229 | 4,7 | 0 | 13,5 | 0 | 443 | 223 | 0 | 12 | 0 | 0 |
| 44 | 0 | 0 | 0 | 0 | 0 | 0 | 450 | 466 | 0 | 13 | 0 | 60 |
| 45 | 0 | 0 | 0 | 0 | 0 | 0 | 452 | 464 | 0 | 19 | 0 | 59,5 |
| 46 | 0 | 0 | 0 | 0 | 0 | 0 | 454 | 462 | 0 | 25 | 0 | 59 |
| 47 | 0 | 0 | 0 | 0 | 0 | 0 | 456 | 460 | 0 | 31 | 0 | 58,5 |
| 48 | 0 | 0 | 0 | 0 | 0 | 0 | 458 | 458 | 0 | 37 | 0 | 58 |
| 49 | 0 | 0 | 0 | 0 | 0 | 0 | 460 | 456 | 0 | 43 | 0 | 57,5 |
| 50 | 0 | 0 | 0 | 0 | 0 | 0 | 462 | 454 | 0 | 49 | 0 | 57 |
| 51 | 0 | 0 | 0 | 0 | 0 | 0 | 464 | 452 | 0 | 55 | 0 | 56,5 |
| 52 | 0 | 0 | 0 | 0 | 0 | 0 | 450 | 466 | 0 | 61 | 0 | 60 |
| 53 | 0 | 0 | 0 | 0 | 0 | 0 | 452 | 464 | 0 | 67 | 0 | 59,5 |
| 54 | 0 | 0 | 0 | 0 | 0 | 0 | 454 | 462 | 0 | 73 | 0 | 59 |
| 55 | 0 | 0 | 0 | 0 | 0 | 0 | 456 | 460 | 0 | 79 | 0 | 58,5 |
| 56 | 0 | 0 | 0 | 0 | 0 | 0 | 458 | 458 | 0 | 85 | 0 | 58 |
| 57 | 0 | 0 | 0 | 0 | 0 | 0 | 460 | 456 | 0 | 68 | 0 | 57,5 |
| 58 | 0 | 0 | 0 | 0 | 0 | 0 | 462 | 454 | 0 | 51 | 0 | 57 |
| 59 | 0 | 0 | 0 | 0 | 0 | 5 | 464 | 452 | 0 | 50 | 0 | 56,5 |
| 60 | 1 | 0 | 0 | 0 | 0 | 5 | 466 | 450 | 0 | 49 | 0 | 56 |
| 61 | 2 | 0 | 0 | 0 | 0 | 5 | 468 | 448 | 0 | 48 | 0 | 55,5 |
| 62 | 2 | 0 | 0 | 0 | 0 | 0 | 470 | 446 | 0 | 47 | 0 | 55 |

## Patentansprüche

1. Druckbares, dispensierfähiges, Ätzmedium zum Ätzen von oxidischen transparenten und leitfähigen Oberflächen und - schichten in Form einer Ätzpaste, enthaltend
a) Phosphorsäure in einer Konzentrationen im Bereich von etwa 35 bis 50 Gew.-%,
b) mindestens ein Lösungsmittel
c) Graphit und/oder Ruß mit einem relativen Partikeldurchmesser im Bereich von 20 nm bis 80 nm und einer spezifischen BET Oberfläche im Bereich von 40 bis 100 m²/g, in einer Menge von weniger 8 Gew.-%, jedoch mehr als 0,5 Gew.-%,
d) gegebenenfalls Verdickungsmittel, und
e) gegebenenfalls Additive wie Entschäumungsmittel, Thixotropiermittel, Verlaufsmittel, Entlüfter, Haftvermittler.

2. Ätzmedium nach Anspruch 1, enthaltend Graphit- oder Rußpulver mit relativen Partikeldurchmessern von weniger als 50 nm und einer spezifischen BET Oberfläche im Bereich 50 bis 70 m²/g.

3. Ätzmedium nach Anspruch 1, enthaltend Graphit- oder Rußpulver mit relativen Partikeldurchmessern im Bereich von 30 nm bis 45 nm.

4. Ätzmedium nach Anspruch 1, enthaltend Rußpulver mit einem relativen Partikeldurchmesser von 40 nm und von einer spezifischen BET Oberfläche von 62 m²/g.

5. Ätzmedium nach einem oder mehreren der Ansprüche 1 bis 4, enthaltend Graphit- oder Rußpulver in einer Menge von 3 bis 7 Gew.-% und einer Viskosität im Bereich von 25 bis 35 Pas..

6. Verwendung eines Ätzmediums nach einem oder mehreren der Ansprüche 1 bis 5 zum Ätzen von transparenten, leitenden oxidischen Schichten während der Halbleiterherstellung.

7. Verwendung eines Ätzmediums nach einem oder mehreren der Ansprüche 1 bis 5 zum Ätzen von ITO bei Temperaturen zwischen 120-170°C.

## Claims

1. Printable, dispensable etching medium for etching oxidic transparent and conductive surfaces and surface layers in the form of an etching paste comprising
a) phosphoric acid in a concentration in the range from about 35 to 50% by weight,
b) at least one solvent,
c) graphite and/or carbon black having a relative particle diameter in the range from 20 nm to 80 nm and a specific BET surface area in the range from 40 to 100 m²/g, in an amount of less than 8% by weight, but more than 0.5% by weight,
d) optionally thickeners, and
e) optionally additives, such as antifoams, thixotropic agents, flow-control agents, deaerators and adhesion promoters.

2. Etching medium according to Claim 1, comprising graphite or carbon-black powder having relative particle diameters of less than 50 nm and a specific BET surface area in the range 50 to 70 m²/g.

3. Etching medium according to Claim 1, comprising graphite or carbon-black powder having relative particle diameters in the range from 30 nm to 45 nm.

4. Etching medium according to Claim 1, comprising carbon-black powder having a relative particle diameter of 40 nm and a specific BET surface area of 62 m²/g.

5. Etching medium according to one or more of Claims 1 to 4, comprising graphite or carbon-black powder in an amount of 3 to 7% by weight and a viscosity in the range from 25 to 35 Pas.

6. Use of an etching medium according to one or more of Claims 1 to 5 for etching transparent, conductive oxidic layers during semiconductor manufacture.

7. Use of an etching medium according to one or more of Claims 1 to 5 for etching ITO at temperatures between 120-170°C.

## Revendications

1. Milieu de gravure imprimable et distribuable pour graver des surfaces oxidiques transparentes et conductrice et des couches de surface afférentes sous forme d'une pâte de gravure comprenant :
a) de l'acide phosphorique selon une concentration dans la plage d'environ 35 à 50% en poids,
b) au moins un solvant,
c) du graphite et/ou du noir de carbone présentant un diamètre relatif de particule dans la plage de 20 nm à 80 nm et une aire de surface BET spécifique dans la plage de 40 à 100 m²/g, selon une quantité inférieure à 8% en poids, mais supérieure à 0,5% en poids,
d) en option, des épaississants, et
e) en option, des additifs, tels que des anti-mousses, des agents thixotropiques, des agents de contrôle de flux, des désaérateurs et des stimulateurs d'adhérence.

2. Milieu de gravure selon la revendication 1, comprenant de la poudre de graphite ou de noir de carbone présentant des diamètres relatifs de particule inférieurs à 50 nm et une aire de surface BET spécifique dans la plage de 50 à 70 m²/g.

3. Milieu de gravure selon la revendication 1, comprenant de la poudre de graphite ou de noir de carbone présentant des diamètres relatifs de particule dans la plage de 30 nm à 45 nm.

4. Milieu de gravure selon la revendication 1, comprenant de la poudre de noir de carbone présentant un diamètre relatif de particule de 40 nm et une aire de surface BET spécifique de 62 m²/g.

5. Milieu de gravure selon une ou plusieurs des revendications 1 à 4, comprenant de la poudre de graphite ou de noir de carbone selon une quantité de 3 à 7% en poids et présentant une viscosité dans la plage de 25 à 35 Pas.

6. Utilisation d'un milieu de gravure selon une ou plusieurs des revendications 1 à 5 pour graver des couches oxidiques transparentes et conductrices pendant la fabrication de semiconducteurs.

7. Utilisation d'un milieu de gravure selon une ou plusieurs des revendications 1 à 5 pour graver de l'ITO à des températures entre 120-170°C.
